# EUROPÄISCHE PATENTANMELDUNG

(11) **EP 0 849 380 A2**
(43) Veröffentlichungstag der Anmeldung: **24.06.1998**
(21) Anmeldenummer: 97118284.5
(22) Anmeldetag: 21.10.1997
(51) Int. Cl.: C30B 23/02, C30B 29/40

(54) **Verfahren zur Herstellung stickstoffhaltiger III-V-Halbleiterschichten**

(30) Priorität: 17.12.1996 DE 19652548
(71) Anmelder: SIEMENS AKTIENGESELLSCHAFT, 80333 München (DE)
(72) Erfinder: Tews, Helmut, Dr., 82008 Unterhaching (DE); Schienle, Meinrad, Dr., 81735 München (DE); Averbeck, Robert, Dr., 81371 München (DE)

(57) **Zusammenfassung**

Während des Aufwachsens bleibt die Einstellung der Materialquellen für Al, In und Ga fest, und es wird beim Übergang zum Aufwachsen einer Schicht anderer Mischkristallzusammensetzung der Stickstoffstrom geändert. Ein größerer Stickstoffstrom führt zu einem vermehrten Einbau der schwächer gebundenen Gruppe-III-Elemente in das aufwachsende Material.

## Beschreibung

Die vorliegende Erfindung betrifft ein Verfahren zur Herstellung abrupter Grenzflachen zwischen ternären Nitriden bei der Molekularstrahlepitaxie.

Das Materialsystem der Nitride Galliumnitrid, Indiumnitrid, Aluminiumnitrid und deren ternärer Verbindungen eignet sich aufgrund der Möglichkeit eines direkten Überganges zwischen Leitungsband und Valenzband (direkte Halbleiter) hervorragend für die Realisierung von optoelektronischen Bauelementen im Spektralbereich von Rot bis Ultraviolett. Die hohe chemische und thermische Resistenz ermöglicht ferner Anwendungen in der Sensorik und Hochtemperaturelektronik. Ein geeignetes Verfahren zur Herstellung der Nitride ist die Molekularstrahlepitaxie, bei der binäre, ternäre oder quaternäre Mischkristallzusammensetzungen im Ultrahochvakuum aus Materialströmen der in den Mischkristallzusammensetzungen vorkommenden Elemente abgeschieden werden. Fur die Herstellung von komplexen Bauelementen wie z. B. Lasern und Leuchtdioden mit hohem Wirkungsgrad sind Schichtfolgen aus Schichten unterschiedlicher Mischkristallzusammensetzungen erforderlich. Die Schichten sollten möglichst homogen zusammengesetzt sein, und die Übergange zwischen unterschiedlichen Zusammensetzungen der aufeinanderfolgenden Schichten sollten möglichst abrupt erfolgen. Beispiele dafür sind mehrfache Quantentopf-Strukturen (Multiple Quantum Well, MQW) im aktiven Bereich eines Lasers (z. B. unter Verwendung von InGaN) oder Übergitterstrukturen als Pufferschichten z. B. als alternierende Folge von dünnen Schichten aus abwechselnd AlGaN und GaN. Die Herstellung dieser Schichten erfordert ein abruptes Umstellen der Materialströme aus den Materialquellen für die Elemente Ga, Al und In beim Übergang von einer gewachsenen Schicht auf die nächste aufzuwachsende Schicht.

Das Umstellen der Materialströme (Wachstumsflüsse) wird bisher durch zwei Verfahren ermöglicht: Unterbrechung des Wachstums oder Verdoppelung der Anzahl der Materialquellen. Die Unterbrechung des Wachstums zwischen den verschiedenen Schichten erlaubt die Umstellung der Materialströme der Materiequellen für die Elemente der Gruppe III des Periodensystems dadurch, daß die Temperaturen der Effusionsszellen der Epitaxieanlage geändert werden. Dieses Verfahren hat den Nachteil, daß relativ lange Zeiten vergehen, bis eine Quelle einen neuen stabilen Materialstrom liefert, der für das Aufwachsen der folgenden Schicht erforderlich ist. Außerdem verändert sich die Oberfläche der gewachsenen Halbleiterschichten während der Unterbrechung. Die andere Möglichkeit besteht darin, die Zahl der Materiequellen zu verdoppeln. Jeweils eine Quelle liefert dann den gerade benötigten Materialstrom, und die andere Quelle kann bereits auf den Materialstrom, der für die nachfolgende Schicht benötigt wird, eingestellt werden. Bei Molekularstrahlepitaxieanlagen ist jedoch die maximal mögliche Zahl von Quellen aus geometrischen Gründen sehr begrenzt, so daß eine Verdopplung von Effusionszellen eine beträchtliche Minderung der Einsatzmöglichkeit dieser Anlagen darstellt.

Aufgabe der vorliegenden Erfindung ist es, ein Verfahren zum epitaktischen Aufwachsen von stickstoffhaltigen III-V-Halbleiterschichten unterschiedlicher Mischkristallzusammensetzungen anzugeben, das mit einer Mindestzahl von Materialquellen in einer Epitaxieanlage durchführbar ist und bei dem ein kontinuierliches Aufwachsen von unterschiedlichen Schichten nacheinander möglich ist.

Diese Aufgabe wird mit dem Verfahren mit den Merkmalen des Anspruches 1 gelöst. Weitere Ausgestaltungen ergeben sich aus den abhängigen Ansprüchen.

Das Materialsystem der Nitride ermöglicht - im Gegensatz zu Arseniden oder Phosphiden - Wachstumsbedingungen, bei denen die Gruppe-III-Elemente (Ga, Al, In) im Überschuß angeboten werden. Bei den üblichen Wachstumstemperaturen desorbiert das überschüssige Material, ohne daß sich die thermisch sehr stabilen Nitride zersetzen. Bietet man daher mehrere Elemente der Gruppe III gleichzeitig an, so werden von dem gesamten Überschuß dieser Elemente die am schwächsten gebundenen Elemente bevorzugt desorbiert. Es werden also die Elemente, die in der Mischkristallzusammensetzung stärker gebunden werden, bevorzugt abgeschieden. Geht man von gruppe-III-reichen Wachstumsbedingungen zu stickstoffreichen Wachstumsbedingungen über, so werden zunehmend auch die schwächer gebundenen Elemente in die aufwachsende Mischkristallzusammensetzung eingebaut. Aus diesem Grund läßt sich bei konstantem Angebot an Materialfluß der Elemente Al, Ga und In die Zusammensetzung der aufwachsenden Halbleiterschicht allein durch Variation des Stickstoffstromes beeinflussen.

Bei der praktischen Anwendung des Verfahrens werden die Materiequellen, die die Elemente der Gruppe III (Al, Ga, In) liefern, fest eingestellt. Die Materialströme dieser Elemente ändern sich daher nicht oder nur als Folge eines geänderten Stickstoffstromes. Die Materialquelle, die den Stickstoff liefert, wird jeweils wahrend des Aufwachsens einer bestimmten Halbleiterschicht fest eingestellt. Wenn die Schicht vollständig aufgewachsen ist, wird der Stickstoffstrom so geändert, daß die Wachstumsbedingungen für die nachfolgend aufzuwachsende Schicht erfüllt sind. Dieses Umstellen des Stickstoffstromes kann sehr rasch erfolgen. Ebenso rasch ändert sich die Zusammensetzung des aufwachsenden Halbleitermateriales. Bei üblichen Molekularstrahlepitaxieanlagen ist eine Plasma-Quelle zur Erzeugung des für das Wachstum der Schichten nötigen atomaren Stickstoffs vorhanden. Der Stickstoffstrom läßt sich leicht und schnell durch den Strom des in die Plasmazelle einströmenden molekularen Stickstoffes verändern. Während des Wachstums der MQW- oder Übergitter-Schichtfolgen kann zu jedem Zeitpunkt problemlos die Menge des angebotenen atomaren Stickstoffs verändert und damit ohne Unterbrechung der Einbau der am schwächsten gebundenen III-Komponente (z. B. In in InGaN) variiert werden. Das erfindungsgemäße Verfahren ermöglicht daher unter Verwendung herkömmlicher Epitaxieanlagen die einfache Realisierung von abrupten, hochwertigen Grenzflächen zwischen binären und ternären oder zwischen ternären und anderen ternären Mischkristallszuammensetzungen ohne Unterbrechung des Wachstums.

## Patentansprüche

1. Verfahren zum epitaktischen Aufwachsen von mindestens zwei Halbleiterschichten, die unterschiedliche Mischkristallzusammensetzungen aus Stickstoff und aus einem oder mehreren Elementen aus der Gruppe von Aluminium, Gallium und Indium besitzen, unter Verwendung einer Epitaxieanlage,
**dadurch gekennzeichnet,**
daß während des Aufwachsens beim Übergang von einer gewachsenen Schicht zu der nächsten aufzuwachsenden Schicht der pro Zeiteinheit zugeführte Anteil an Stickstoff geändert wird.

2. Verfahren nach Anspruch 1,
bei dem während des Aufwachsens die Materialquellen für mindestens zwei Elemente aus der Gruppe von Aluminium, Gallium und Indium auf so hohe Materialströme fest eingestellt bleiben, daß allein mit einer Änderung des Stickstoffstromes alle für die aufzuwachsenden Schichten vorgesehenen Mischkristallzusammensetzungen hergestellt werden.

3. Verfahren nach Anspruch 1 oder 2,
bei dem eine Molekularstrahlepitaxieanlage mit einer Plasma-Quelle für atomaren Stickstoff verwendet wird und bei dem der pro Zeiteinheit zugeführte Anteil an Stickstoff dadurch geändert wird, daß der Strom des in die Plasma-Quelle eingelassenen molekularen Stickstoffes geändert wird.
